# EUROPÄISCHE PATENTANMELDUNG

(11) **EP 1 710 907 A1**
(43) Veröffentlichungstag der Anmeldung: **11.10.2006**
(21) Anmeldenummer: 05007383.2
(22) Anmeldetag: 05.04.2005
(51) Int. Cl.: H03D 7/16, H03G 11/00

(54) **System zur Leistungsoptimierten Wiedergabe von Sprache**

(71) Anmelder: Siemens Schweiz AG, 8047 Zürich (CH)
(72) Erfinder: Vollenweider, Walter, 8712 Stäfa (CH)
(74) Vertreter: Hellebrandt, Martin

(57) **Zusammenfassung**

Ein System zur Wiedergabe eines akustischen Signals hat eine sendeseitig angeordnete Signalquelle (1) für ein einem akustischen Signal entsprechendes elektrisches Signal, und eine das elektrische Signal empfangende Signalverarbeitungseinrichtung (7, 8). Die Signalverarbeitungseinrichtung (7, 8) setzt das elektrische Signal von einem ersten Frequenzband in ein zweites Frequenzband um. Ausserdem begrenzt die Signalverarbeitungseinrichtung (7, 8) die Amplitude des elektrischen Signals im zweiten Frequenzband, filtert es und setzt das so verarbeitete elektrische Signal vom zweiten Frequenzband in das erste Frequenzband um. Eine empfangseitig angeordnete Wiedergabeeinrichtung (6) empfängt das verarbeitete elektrische Signal und wandelt es in ein akustisches Signal um.

## Beschreibung

Die hier beschriebenen Ausführungsbeispiele betreffen die Verarbeitung von Signalen, die zur Wiedergabe als akustische Signale bestimmt sind, insbesondere zur leistungsoptimierten Sprachwiedergabe durch einen Lautsprecher.

Bei bekannten Übertragungssystemen für Sprache wird das von einer Sprachquelle ausgehende akustische Sprachsignale zuerst in ein zur Übertragung geeignetes Signal, beispielsweise in ein elektrisches oder optisches Signal gewandelt. Im Übertragungsweg befinden sich üblicherweise Einrichtungen, die die gewandelten Sprachsignale verarbeiten, zum Beispiel modulieren und verstärken, um die Übertragung der Sprache über ein vorgegebenes Übertragungsmedium zu ermöglichen und zu optimieren. Am Ende der Übertragungsstrecke wird das übertragene Signal mit Hilfe von beispielsweise einem Lautsprecher wieder in ein akustisches Signal gewandelt und wiedergegeben.

Die Amplitude eines Sprachsignals ist normalerweise im zeitlichen Verlauf nicht konstant. Um eine genügende Verständlichkeit zu gewährleisten sollte sichergestellt werden, dass auch leisere Stellen des Sprachsignals mit einem den Umständen und Vorschriften angepassten minimalen Pegel wiedergegeben werden. Man wird allerdings nicht fordem können, dass auch die leisesten Stellen mit diesem Pegel wiedergegeben werden, da Sprache Pausen enthalten kann, in denen überhaupt kein Signal vorhanden ist. Vielmehr wird man einen geeigneten Mittelwert definieren und fordern, dass dieser Mittelwert einen bestimmten Pegel erreicht oder überschreitet.

Im Sprachsignal sind normalerweise auch Stellen vorhanden, deren Amplitude wesentlich grösser als der Mittelwert ist. Das Verhältnis von Spitzenwert zu Mittelwert kann z. B. 15 dB, d.h. ein Leistungsverhältnis von 30:1 sein. Bei ungünstigen Umständen, beispielsweise wenn der Sprecher nicht geübt ist kann dieses Verhältnis noch wesentlich höher liegen.

Die Sprachqualität und Sprachverständlichkeit nach der Wandlung und Wiedergabe hängt von verschieden Faktoren ab. Ein Faktor ist die Aussteuerbarkeit der im System vorhandenen elektrischen Einrichtungen, vor allem der Verstärkereinrichtungen, da jede Verstärkereinrichtung nur innerhalb bestimmter Grenzen verzerrungsfrei aussteuerbar ist. Soll die Verstärkereinrichtung nicht übersteuern, ist der Sprachsignalpegel so einzustellen, dass der Spitzenwert der Sprache etwa der maximalen Leistung der Verstärkereinrichtung entspricht. Der Mittelwert der Sprache ist dann entsprechend beispielsweise 15 dB kleiner. Ein um 15 dB reduzierter Mittelwert kann für manche Anwendungen jedoch bereits zu leise sein.

Die genannten Schwierigkeiten treten grundsätzlich bei allen Verfahren zur Sprachübertragung, also auch in einem System zur Übertragung eines akustischen Signals über eine Übertragungsvorrichtung von einer Sendeseite zu einer Empfangsseite, auf. Ein solches System hat einen sendeseitig angeordneten Wandler, der ein akustisches Signal in ein elektrisches Signal wandelt, und empfangsseitig einen weiteren Wandler der das elektrische Signal in ein akustisches Signal wandelt. Der empfangsseitige Wandler und der vorgeschaltete Verstärker können nur bis zu einer gewissen Grenze ausgesteuert werden. Diese Grenze kann zwar erhöht werden, dazu ist aber ein beträchtlicher Aufwand notwendig. Es ist bekannt, dass weitere Teile des Übertragungspfades ebenfalls nur bis zu einer gewissen Grenze ausgesteuert werden können. Die Pegel werden so gewählt werden, dass die auf Übersteuerung empfindlichen Teile des Übertragungspfades erst dann übersteuert werden, wenn die Übersteuerung des empfangsseitigen Wandlers und des vorgeschalteten Verstärkers bereits erfolgt ist, da so der empfangsseitige Wandler und der vorgeschaltete Verstärker bestmöglich ausgenützt werden können.

Bekannte Vorrichtungen lösen diese Schwierigkeiten nicht vollständig in der gewünschten Weise. Eine Art von Vorrichtungen sind automatisch geregelte Verstärker. Automatisch geregelte Verstärker haben ein zeitliches Verhalten, das nicht in optimaler Weise an die tatsächlichen Verhältnisse angepasst werden kann. Eine weitere Art von Vorrichtungen sind Begrenzer mit einer nichtlinearen Kennlinie, die das Sprachsignal im erlaubten Bereich halten und zulassen, dass in der Folge Harmonische und Intermodulationsprodukte entstehen. Solche unerwünschten Komponenten können mit nachgeschalteten Filtern entfernt werden, wenn sie ausserhalb des Sprachbandes liegen. Unerwünschte Komponenten im Sprachband lassen sich dagegen nicht entfernen und können störend wirken.

Es besteht daher die Aufgabe, ein System und Verfahren zur Wiedergabe von akustischen Signalen anzugeben, die ohne Regelverstärker und Begrenzer mit nichtlinearer Kennlinie auskommen, aber trotzdem gegenüber herkömmlichen Systemen eine verbesserte und damit leistungsoptimierte Wiedergabe von akustischen Signalen ermöglichen.

Ein Aspekt der im Folgenden beschriebenen Ausführungsbeispiele betrifft ein System zur Wiedergabe eines akustischen Signals. Das System hat eine sendeseitig angeordnete Signalquelle für ein einem akustischen Signal entsprechendes elektrisches Signal in einem ersten Frequenzbereich. Eine Signalverarbeitungseinrichtung empfängt das elektrische Signal und setzt es vom ersten Frequenzband in ein zweites Frequenzband um. Die Signalverarbeitungseinrichtung filtert das elektrische Signal im zweiten Frequenzband, begrenzt seine Amplitude und filtert es wieder. Danach setzt die Signalverarbeitungseinrichtung das elektrische Signal wieder vom zweiten Frequenzband in das erste Frequenzband um. Eine Wiedergabeeinrichtung wandelt das verarbeitete elektrische Signal in ein akustisches Signal.

Ein weiterer Aspekt betrifft ein Verfahren zur leistungsoptimierten Wiedergabe eines akustischen Signals. Ein akustisches Signal wird in einem ersten Frequenzband in ein elektrisches Signal umgewandelt wird, und von einem ersten Frequenzband in ein zweites Frequenzband umgesetzt. Das elektrische Signal im zweiten Frequenzband wird amplitudenbegrenzt und gefiltert, und vom zweiten Frequenzband in das erste Frequenzband umgesetzt. Das so verarbeitete elektrische Signal wird in ein akustisches Signal umgewandelt wird.

Ein zusätzlicher Aspekt betrifft eine Gefahrenmeldeanlage mit mehreren Gefahrenmeldern, die jeweils einen Lautsprecher zur Wiedergabe eines akustischen Alarmsignals oder einer Sprachmeldung, und einem System zur leistungsoptimierten Wiedergabe eines akustischen Signals, das die genannte Signalverarbeitungseinrichtung enthält. Die in den Gefahrenmeldern vorhandenen Lautsprecher geben sowohl das akustische Signal als auch eine Durchsage von Evakuierungsinformation wieder.

Die hier beschriebenen Ausführungsbeispiele eines Systems zur Wiedergabe eines akustischen Signals zeichnen sich dadurch aus, dass die Übersteuerung des empfangsseitigen Verstärkers und Wandlers nicht mit den dem Fachmann bekannten Abhilfemassnahmen wie Regelverstärker, Begrenzer mit nachfolgenden Filtern oder mit anderen bekannten Massnahmen bekämpft werden, sondern dass eine sonst nicht zu diesem Zweck benutzte Signalverarbeitungseinrichtung (HF-Clipper) verwendet wird.

In einem System zur Übertragung von Sprache über eine Funkstrecke in Einseitenbandtechnik sind je ein elektroakustischer Wandler am Anfang und Ende der Übertragungsstrecke, und verschiedene andere Vorrichtungen innerhalb des Signalpfades zwischen den beiden Wandlern vorhanden. In einer solchen Übertragungsstrecke kann der empfängerseitige Wandler und ein vorgeschalteter Verstärker normalerweise so ausgestaltet sein, dass sie auch bei den grössten vorkommenden Signalen nicht übersteuert werden. Dagegen wird es normalerweise nicht möglich sein, einen Modulator beziehungsweise den Sender und insbesondere den Hochfrequenzverstärker auf der Seite des Senders so zu gestalten, dass er mit Sicherheit nicht übersteuert werden kann, da dies bedingen würde, dass er für eine Spitzenleistung dimensioniert wird, die sehr viel höher als die mittlere Sendeleistung ist und dies wiederum zusätzliche Kosten zur Folge hätte.

Es kann deshalb eine Signalverarbeitungseinrichtung vorgeschaltet werden, die das Sprachsignal in einem Bereich hält, der noch keine Übersteuerung des Hochfrequenzverstärkers zur Folge hat. Hier kann eine Einrichtung der zwei oben genannten Arten, nämlich ein automatisch geregelter Verstärker oder ein Begrenzer mit nachgeschalteten Filtern, die Frequenzkomponenten ausserhalb des Sprachbandes entfernen, verwendet werden.

In der Hochfrequenztechnik wird gelegentlich eine Einrichtung verwendet, die als HF-Clipper bezeichnet wird. Brian Austin beschreibt in "The SSB Manpack And Its Pioneers in Southern Africa - Part1", Radio Bygones No. 93 vom Februar/März 2005, einen Sender in Einseitenbandtechnik mit einem Begrenzer. Brian Austin verwendet dabei den Begriff "logarithmische Kompression", das jedoch dem Prinzip eines HF-Clippers entspricht.

Der HF-Clipper eignet sich zur Verarbeitung von Signalen wie beispielsweise einem Sprachsignal. Das Sprachsignal belegt beispielsweise einen Frequenzbereich von ca. 300 Hz bis ca. 3,4 kHz. Der genannte Frequenzbereich ist im Folgenden als Basisband bezeichnet. Das Sprachsignal hat eine Amplitude und einen zeitlichen Amplitudenverlauf der u. a. vom gesprochenen Text, vom Sprecher, der Lautstärke der Sprache und vom Abstand des Sprechers vom Mikrofon abhängt.

Dieser erwähnte HF-Clipper ist auf dem Gebiet der Hochfrequenztechnik bekannt, insbesondere um die Aussteuerung von Sendern in Einseitenbandtechnik zu begrenzen. HF-Clipper werden zunehmend durch Regelverstärker abgelöst, die mit Hilfe von digitaler Signalverarbeitung realisiert werden können. Solche Regelverstärker können sich in der professionellen Funktechnik bewähren, weil die Sprecher in der Regel geübt sind, und weil meistens derselbe Sprecher mit einem bestimmten Gerät arbeitet und deshalb die Zeitkonstanten des Regelverstärkers auf die Eigenschaften und Gewohnheiten des Sprechers eingestellt werden können. Im Falle einer Gefahrenmeldeanlage sind diese Voraussetzungen jedoch nicht gegeben.

Diese und weitere Aspekte, Vorteile und neue Merkmale der beschriebenen Ausführungsbeispiele werden beim Studium der folgenden detaillierten Beschreibung mit Bezug auf die beiliegenden Zeichnungen deutlich. In den Zeichnungen haben gleiche Elemente die gleichen Bezugszeichen. Es zeigen:
Fig. 1 eine schematische Darstellung eines beispielhaften Systems zur Wiedergabe von akustischen Signalen; und
Fig. 2 eine schematische Darstellung einer Signalverarbeitungseinrichtung.

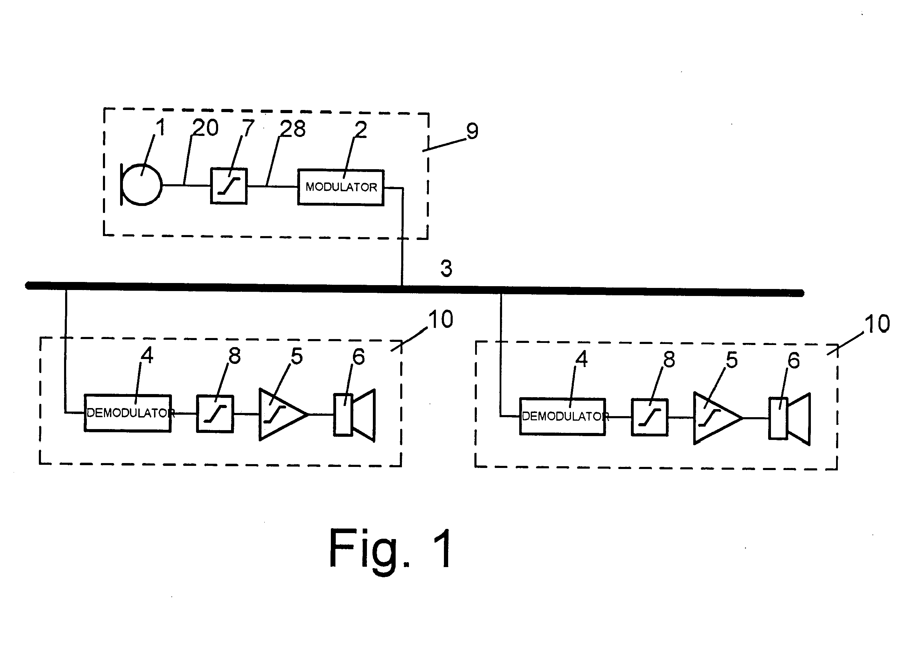

Figur 1 zeigt eine schematische Darstellung eines Ausführungsbeispiels eines Systems zur Wiedergabe von akustischen Signalen. In der folgenden Beschreibung sind die akustischen Signale Sprachsignale. Der Frequenzbereich von Sprache liegt in einem Frequenzband zwischen etwa 300 Hz und etwa 3,4 kHz. Der Fachmann erkennt jedoch, dass Sprache nur ein Beispiel für ein akustisches Signale ist, und dass im Allgemeinen akustische Signale von Menschen hörbar sind, die in einem Frequenzband zwischen etwa 20 Hz und etwa 20 kHz liegen und somit Sprache mit einschliessen.

Auf einer Sendeseite enthält das gezeigte System eine Sendeeinrichtung 9 mit einem elektroakustischem Wandler 1 als Signalquelle, einer Signalverarbeitungseinrichtung 7 und einem Modulator 2. Auf einer Empfangsseite enthält das System mindestens eine Empfangseinrichtung 10, die einen Demodulator 4, einen Verstärker 5 und einen elektroakustischen Wandler 6 als Sprachwiedergabeeinrichtung enthält. Eine gezeigte Signalverarbeitungseinrichtung 8 kann je nach Ausführungsbeispiel zwischen dem Demodulator 4 und dem Verstärker 5 geschaltet sein. Ein Übertragungsmedium 3 verbindet die Sendeseite mit der Empfangsseite. Das Übertragungsmedium 3 kann eine elektrische Leitung, aber auch eine beliebige andere Einrichtung sein, die sich zum Übertragen von Signalen eignet. Die ebenfalls eingezeichnete Signalverarbeitungseinrichtung 8 werde in diesem Ausführungsbeispiel als nicht vorhanden gedacht.

Im gezeigten Ausführungsbeispiel ist der elektroakustische Wandler 1 ein Mikrofon, in das eine dazu befugte Person spricht. Als Signalquelle kann auch eine Vorrichtung verwendet werden, in dem eine Sprachmitteilung gespeichert ist, die zu gegebener Zeit wiedergegeben wird. Die Signalquelle kann ausserdem auch eine Vorrichtung sein, die Sprache oder ein anderes Signal synthetisch herstellt, oder eine beliebige Vorrichtung, die ein Signal ausgibt, das sich zur Kommunikation mit Personen eignet.

Die Signalverarbeitungseinrichtung 7 ist nach dem Prinzip des HF-Clippers aufgebaut. Das Signal vom Wandler 1 gelangt über einen Eingang 20 in die Signalverarbeitungseinrichtung 7, und verlässt diese über einen Ausgang 28.

Der Modulator 2 empfängt das verarbeitete Sprachsignal vom Ausgang 28 der Signalverarbeitungseinrichtung 7 und passt das empfangene Sprachsignal an die Eigenschaften des Übertragungsmediums 3 an. Je nach den für ein Ausführungsbeispiel vorgegebenem Übertragungsmedium 3 hat der Modulator 2 eine unterschiedliche Struktur und Funktion: Wenn das Übertragungsmedium 3 eine Telefonleitung ist, passt der Modulator 2 beispielsweise die Ausgangsimpedanz der Signalverarbeitungseinrichtung 7 an die Impedanz der Telefonleitung an. Wenn das Übertragungsmedium 3 eine Funkstrecke ist, setzt der Modulator 2 den Frequenzbereich des Sprachsignals auf eine für Funkübertragung geeignete Frequenz um. Auch bei einer Übertragung über eine Leitung einer Gefahrenmeldeanlage kann eine Frequenzumsetzung erfolgen. Zusätzlich kann der Modulator 2 für den Einsatz bei den genannten Übertragungsmedien so ausgebildet sein, dass er das Sprachsignal digitalisiert. Der Modulator 2 kann ausserdem dafür vorgesehen sein, bei Bedarf das Sprachsignal zu verstärken.

Der auf der Empfangsseite an das Übertragungsmedium 3 gekoppelte Demodulator 4 setzt das übertragene und empfangene Signal wieder in ein geeignetes elektrisches Sprachsignal um. Die Art des Demodulators 4 hängt von der durch das Übertragungsmedium 3 geprägten Art des Modulators 2 ab. Wenn das Übertragungsmedium 3 zum Beispiel eine Telefonleitung ist, enthält der Demodulator 4 eine Impedanzanpassungsschaltung und, abhängig von im Übertragungsmedium 3 auftretenden Verlusten, einen Verstärker. Ist das Übertragungsmedium 3 eine Funkstrecke, enthält der Demodulator 4 die Komponenten, die das Funksignal wieder in ein elektrisches Signal im Basisband wandeln. Bei einer digitalisierten Übertragung des Sprachsignals kann der Demodulator 4 einen Digital/Analogwandler enthalten. Die Struktur und Funktion des Modulators 2 und des Demodulators 4 sind einem Fachmann wohlbekannt.

Der Verstärker 5 ist dem Demodulator 4 nachgeschaltet und verstärkt das Ausgangssignal des Demodulators 4 auf einen genügend grossen Pegel. Der elektroakustische Wandler 6 enthält einen Lautsprecher, der das verstärkte elektrische Sprachsignal in ein akustisches Sprachsignal wandelt.

Als willkommene Nebenwirkung schützt die Signalverarbeitungseinrichtung 7 nicht nur die Verstärker 5 und Lautsprecher 6 vor Übersteuerung, sondern die Signalpegel im System können so gewählt werden, dass die Signalverarbeitungseinrichtung 7 auch den Modulator 2, den Übertragungspfad 3 und die Demoulatoren 4 vor Übersteuerung schützt.

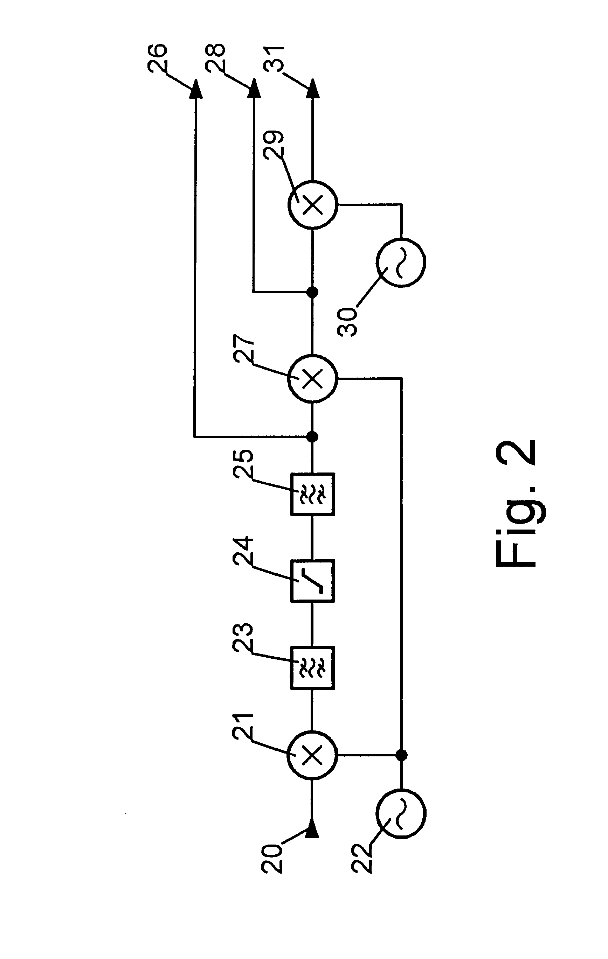

Figur 2 zeigt eine schematische Darstellung eines Ausführungsbeispiels der Signalverarbeitungseinrichtung 7 nach dem Prinzip des HF-Clippers. Das Eingangssignal im Basisband gelangt über den Eingang 20 zu einem ersten Frequenzumsetzer 21. Dieser Frequenzumsetzer 21 erhält von einem ersten Oszillator 22 ein Lokaloszillatorsignal mit der Frequenz f_{LO}. Normalerweise entstehen aus einer Komponente des Eingangssignals mit f₁ nach dem Umsetzer 21 zwei Komponenten mit den Frequenzen f_{LO} + f₁ und f_{LO} - f₁. Ein Sprachsignal enthält normalerweise mehrere Signalkomponenten mit verschiedenen Frequenzen, so dass nach dem Umsetzer 21 entsprechend viele Signalkomponenten vorhanden sind. Das nachfolgende erste Filter 23 ist in einem Ausführungsbeispiel als Bandpassfilter ausgelegt und unterdrückt entweder die Komponenten unterhalb oder oberhalb der Lokaloszillatorfrequenz, währenddem die anderen Signalkomponenten nahezu unverändert durchgelassen werden.

Im nachfolgenden Begrenzer 24 wird die Amplitude des Signals, das mehrere Komponenten mit verschiedenen Frequenzen enthalten kann, auf einen zweckmässigen Wert begrenzt. Durch die Wirkung des Begrenzers 24 entstehen zusätzliche unerwünschte Signalkomponenten, und zwar auf Vielfachen der Frequenzen der einzelnen Komponenten aber auch auf weiteren Frequenzen. In einem zweiten Filter 25, das in einem Ausführungsbeispiel ebenfalls als Bandpass ausgelegt ist, werden einige der im Begrenzer 24 entstandenen unerwünschten Signalkomponenten unterdrückt.

Wenn die Frequenz des Oszillators 22 so gewählt ist, so dass die Frequenz der nach dem Filter 25 noch vorhandenen Signalkomponenten im zulässigen Bereich der Sendefrequenz liegt, kann das Signal über den Ausgang 26 direkt einem Hochfrequenzverstärker der Sendeeinrichtung 9 zugeführt werden. In vielen Fällen ist es aber vorteilhaft, die Frequenz des Oszillators 22 mit Rücksicht auf die Eigenschaften der Filter 23 und 25 so zu wählen, dass das Signal am Ausgang 26 in einem Frequenzbereich liegt, der nicht der Sendefrequenz entspricht. In diesem Fall wird das Signal mit einem zweiten Frequenzumsetzer 27, der dasselbe Lokaloszillatorsignal wie der erste Frequenzumsetzer 22 erhält, wieder in das Basisband und somit in den Frequenzbereich umgesetzt, in dem bereits das am Eingang 20 eingespiesene Signal lag. Dieses Signal kann am Ausgang 28 abgegriffen werden. Bis zu diesem Ausgang 28 können die vorher erwähnten Komponenten in einem Gerät zusammengefasst werden und beispielsweise mit einem Mikrofon zusammengebaut werden kann.

Es ist aber auch möglich, nach dem zweiten Frequenzumsetzer 27, einen dritten Frequenzumsetzer 29 vorzusehen, der das Lokaloszillatorsignal von einem zweiten Oszillator 30 erhält. Wenn die Frequenz des Oszillators 30 geeignet gewählt wird, kann das Signal an einem Ausgang 31 einem Hochfrequenzverstärker zugeführt werden und als Steuersignal der Sendeeinrichtung 9 dienen.

Die beschriebenen Ausführungsbeispiele eines Systems zur Wiedergabe eines akustischen Signals zeichnen sich dadurch aus, dass die Übersteuerung des in Figur 1 gezeigten Verstärkers 5 und des Wandlers 6 nicht mit den dem Fachmann bekannten Abhilfemassnahmen wie Regelverstärker, Begrenzer mit nachfolgenden Filtern oder mit anderen bekannten Massnahmen bekämpft werden, sondern dass eine Signalverarbeitungseinrichtung mit einem HF-Clipper verwendet wird, der sonst nicht zu diesem Zweck benutzt wird.

Das vorstehend beschriebene erste Ausführungsbeispiel betrifft ein Verfahren zur leistungsoptimierten Wiedergabe eines akustischen Signals. Ein akustisches Signal wird in ein elektrisches Signal umgewandelt, und von einem ersten Frequenzband in ein zweites Frequenzband umgesetzt. Das elektrische Signal im zweiten Frequenzband wird gefiltert, amplitudenbegrenzt und nochmals gefiltert, und vom zweiten Frequenzband in das erste Frequenzband umgesetzt. Das so verarbeitete elektrische Signal wird in ein akustisches Signal umgewandelt.

Ein zweites Ausführungsbeispiel betrifft eine Gefahrenmeldeanlage, wobei sich der in Figur 1 gezeigte Wandler 1, der Verstärker 5 und der Wandler 6 in demselben Gehäuse befindet. Der Modulator 2, das Übertragungsmedium 3 und der Demodulator 4 entfallen in diesem Ausführungsbeispiel beziehungsweise können als durch elektrische Verbindungen im Innern des Gehäuses gegeben betrachtet werden. Im zweiten Ausführungsbeispiel ist wie im ersten Ausführungsbeispiel eine Signalverarbeitungseinrichtung nach dem Prinzip des HF-Clippers vorhanden, wobei diese infolge Fehlens des Modulators 2, des Übertragungsmediums 3 und des Demodulators 4 entweder als Signalverarbeitungseinrichtung 7 oder 8 in der Figur 1 aufgefasst werden kann. Das Signal vom Wandler 1 gelangt über den Eingang 20 in die Signalverarbeitungseinrichtung 7 und wird über den Ausgang 28 dem Verstärker 5 zugeführt.

Das zweite Ausführungsbeispiel kann vollständig im Gehäuse eines Gefahrenmelders untergebracht sein. In diesem Ausführungsbeispiel empfängt der Wandler 1 beispielsweise einen im gemeinsamen Gehäuse gespeicherten Text, wobei jedoch weitere Möglichkeiten zur Erzeugung des Sprachsignals, wie oben beschrieben, nicht ausgeschlossen sind.

Ein drittes Ausführungsbeispiel betrifft wiederum eine Gefahrenmeldeanlage mit einer Sendeeinrichtung und einer Signalverarbeitungseinrichtung nach dem Prinzip des HF-Clippers. Hier sind jedoch mehrere Empfangseinrichtungen 10 mit Vorrichtungen zur Wiedergabe eines akustischen Alarmsignals oder einer Sprachmeldung vorhanden.

Ein viertes Ausführungsbeispiel betrifft wiederum eine Gefahrenmeldeanlage ähnlich dem dritten Ausführungsbeispiel mit einer Sendeeinrichtung und einer oder mehreren Empfangseinrichtungen 10 mit Vorrichtungen zur Wiedergabe eines akustischen Alarmsignals oder einer Sprachmeldung. Im vierten Ausführungsbeispiel wird jedoch statt einer Signalverarbeitungseinrichtung 7 in der Sendeeinrichtung 9 eine oder mehrere gleichartige Signalverarbeitungseinrichtungen 8 nach dem Prinzip des HF-Clippers in den Empfangseinrichtungen 10 verwendet. In diesem Anwendungsbeispiel werde die Signalverarbeitungseinrichtung 7 als nicht vorhanden gedacht.

Die Anordnung der Signalverarbeitungseinrichtung 8 in der Empfangseinrichtung 10 kann beispielsweise zweckmässig sein, wenn die Verstärker 5 und Lautsprecher 6 in den verschiedenen Empfängern unterschiedliche Eigenschaften haben und die Signalverarbeitungseinrichtungen 8 so in bestmöglicher Weise diesen Eigenschaften angepasst werden können. Die Anordnung der Signalverarbeitungseinrichtungen 8 in den Empfängern erfordert, dass in jeder Empfangseinrichtung 10 eine solche Signalverarbeitungseinrichtung 8 vorhanden sein muss, währendem eine Signalverarbeitungseinrichtung 7 in der Sendeeinrichtung 9 nur einmal vorhanden ist.

Es versteht sich in allen Ausführungsbeispielen, dass den im System vorhandenen Komponenten, je nach Art der Komponenten, elektrische Energie zur Verfügung steht. Dies kann in einem Ausführungsbeispiel durch Anschluss an eine Gebäudespannungsversorgung erfolgen. In einem anderen Ausführungsbeispiel können alle oder nur einige Komponenten an separate Akkumulatoren oder Primärzellen angeschlossen sein, die die Energie für die Komponenten liefern.

Eine Komponente des Systems, die notwendigerweise mit Energie versorgt werden muss ist der Verstärker 5. Je nach der Art des Übertragungsmediums 3 kann es erforderlich sein, ebenfalls den Demodulator 4 mit Energie zu versorgen. Je nach der Art des Übertragungsmediums 3 kann es möglich sein, gleichzeitig mit den Sprach- oder Alarmsignalen auch elektrische Energie zu übertragen. Falls dies möglich ist, kann in einem Ausführungsbeispiel die elektrische Energie mit einer in Figur 1 nicht gezeigten, geeigneten Vorrichtung aus dem Übertragungsmedium ausgekoppelt und insbesondere dem Verstärker 5, aber auch allen andern Komponenten die mit Energie versorgt werden müssen, zugeführt werden.

Ist das Übertragungsmedium 3 eine Brandmelderleitung, kann in den meisten Fällen nur wenig elektrische Energie übertragen werden, die nicht genügt, um den Verstärker 5 zu betreiben. Sollte diese der Fall sein, kann in einem Ausführungsbeispiel zwischen der oben erwähnten Auskoppelschaltung und dem Verstärker 5 und weiteren mit elektrischer Energie zu versorgenden Komponenten ein in Figur 1 nicht gezeigter Akkumulator eingeschaltet werden. Die über das Übertragungsmedium 3 übertragene Akkumulator eingeschaltet werden. Die über das Übertragungsmedium 3 übertragene Energie kann nun verwendet werden, um in der Zeit, in der noch keine Gefahren gemeldet wurden und somit keine Alarmsignale oder Sprachdurchsagen erforderlich sind, den Akkumulator zu laden, so dass im Alarmfall genügend Energie gespeichert ist, um den Verstärker 5 und weitere Komponenten zu speisen.

In einem weiteren Anwendungsbeispiel ist der Verstärker 5 und weitere mit elektrischer Energie zu versorgende Komponenten an Primärzellen oder an eine andere geeignete Spannungsversorgung angeschlossen.

Im ersten, zweiten und dritten Ausführungsbeispiel sind die sendeseitigen Komponenten Wandler 1, Modulator 2 und gegebenenfalls Signalverarbeitungseinrichtung 7 miteinander verbunden und können in einem gemeinsamen Gehäuse 9 zu einer Sendezentrale zusammengebaut werden. Die Sendezentrale kann Teil einer Gefahrenmeldezentrale sein oder auch getrennt davon installiert werden.

Die empfangsseitigen Komponenten Demodulator 4, Verstärker 5 und Lautsprecher 6 und gegebenenfalls Signalverarbeitungseinrichtung 8 sind ebenfalls miteinander verbunden und können in einem Ausführungsbeispiel in einem gemeinsamen Gehäuse angeordnet sein. Das Gehäuse kann in einem Ausführungsbeispiel auch Komponenten eines Gefahrenmelders enthalten.

In einem Ausführungsbeispiel kann das beschriebene Sprachübertragungssystem in Verbindung mit einer Gefahrenmeldeanlage verwendet werden. Bei einer Gefahrenmeldeanlage ist eine Zentrale mit verteilt angeordneten Gefahrenmeldern (zum Beispiel Melder für Rauch, Feuer, Gas oder Einbruch) verbunden. Die Gefahrenmelder sind mit der Zentrale über ein Netz von Melderlinien verbunden, das zur Stromversorgung der Gefahrenmelder und zur Kommunikation mit der Zentrale dient. Detektiert ein Gefahrenmelder beispielsweise einen Brand meldet er diesen der Zentrale, die daraufhin ein akustisches Alarmsignal auslöst.

Einige Länder schreiben für bestimmte Arten von Gebäuden vor, dass die Alarmierung nicht nur mit Hilfe von akustischen Signalen sondern auch mit Sprachdurchsagen zu erfolgen hat. So können mit gezielten Durchsagen (z. B.: "Achtung, im 6. Stock ist ein Feuer ausgebrochen. Verlassen Sie bitte umgehend das Gebäude".) die im Gebäude anwesenden Personen zu zweckmässigem Handeln angeleitet werden. Die Gestaltung der entsprechenden Einrichtung ist beispielsweise in der Europäischen Norm EN 54-16 beschrieben.

Das mit verschiedenen Anwendungsbeispielen beschriebene System zur Wiedergabe von Sprache kann vorteilhaft in einer Gefahrenmeldeanlage verwendet werden, die neben dem Erzeugen eines akustischen Alarmsignals auch die Durchsage von Evakuierungsinformation zulässt. Wenn im Gefahrenmelder ein Lautsprecher vorhanden ist, ist dieser üblicherweise nur für die Wiedergabe eines akustischen Alarmsignals im Frequenzbereich von etwa 1 kHz bis etwa 2 kHz ausgelegt. Ein solcher Lautsprecher und der dazugehörige Verstärker sind üblicherweise auch nur so ausgelegt, dass ein Warnsignal mit einem konstanten Pegel mit einer genügenden Lautstärke wiedergegeben werden kann. Für die Wiedergabe von Sprache oder einem anderen Signal mit nicht konstantem Pegel muss die Aussteuerung soweit reduziert werden, dass weder der Lautsprecher noch der Verstärker übersteuert werden. In der Folge ist die Lautstärke in vielen Fällen zu gering, wie oben ausgeführt wurde.

Die beschriebenen Anwendungsbeispiele können dazu verwendet werden, um mit dem im Gefahrenmelder vorhandenen Lautsprecher eine ausreichend laute und verständliche Sprachwiedergabe zu ermöglichen. Die in Figur 1 gezeigten Komponenten Demodulator 4, Verstärker 5 und Lautsprecher 6 befinden sich bei diesem Ausführungsbeispiel zusammen mit einem Gefahrenmelder und gegebenenfalls weiteren Komponenten in einem gemeinsamen Gehäuse. Der Lautsprecher 6 dient demnach zur Wiedergabe eines akustischen Alarmsignals und zur Durchsage der Evakuierungsinformation. Eine separate Installation von Lautsprechern zur Durchsage der Evakuierungsinformation ist nicht erforderlich.

## Patentansprüche

1. System zur leistungsoptimierten Wiedergabe eines akustischen Signals, mit:
- einer Signalquelle (1) für ein einem akustischen Signal entsprechendes elektrisches Signal in einem ersten Frequenzbereich,
- einer das elektrische Signal empfangenden Signalverarbeitungseinrichtung (7, 8), die das elektrische Signal vom ersten Frequenzband in ein zweites Frequenzband umsetzt, im zweiten Frequenzband filtert, amplitudenbegrenzt und wieder filtert, und wieder vom zweiten Frequenzband in das erste Frequenzband umsetzt, und
- einer Wiedergabeeinrichtung (6), die das verarbeitete elektrische Signal in ein akustisches Signal wandelt.

2. System nach Anspruch 1, bei dem die Signalverarbeitungseinrichtung (7, 8)
- einen ersten Umsetzer (21) hat, der aus dem elektrischen Signal im ersten Frequenzband und einem von einem Oszillator (22) erzeugten Referenzsignal das elektrische Signal im zweiten Frequenzband erzeugt,
- ein erstes Filter (23) hat, das festgelegte Frequenzanteile des vom ersten Umsetzer (21) kommenden Signals entfernt,
- einen Begrenzer (24) hat, der das vom ersten Filter (23) kommende elektrische Signal amplitudenbegrenzt,
- ein zweites Filter (25) hat, das festgelegte Frequenzanteile vom amplitudenbegrenzten elektrischen Signal entfernt, und
- einen zweiten Umsetzer (27) hat, der aus dem vom Filter (25) kommenden elektrischen Signal und dem Referenzsignal das verarbeitete elektrische Signal im ersten Frequenzband erzeugt.

3. System nach Anspruch 1 oder 2, bei dem zur Übertragung des elektrischen Signals von einer Sendeseite zu einer Empfangsseite ein Übertragungsmedium (3) vorhanden ist, und bei dem die Signalverarbeitungseinrichtung (7) sendeseitig zwischen der Signalquelle (1) und einem Modulator (2) angeordnet ist.

4. System nach Anspruch 1 oder 2, bei dem zur Übertragung des elektrischen Signals von einer Sendeseite zu einer Empfangsseite ein Übertragungsmedium (3) vorhanden ist, und bei dem die Signalverarbeitungseinrichtung (8) empfangsseitig zwischen dem Übertragungsmedium (3) und der Wiedergabeeinrichtung (6) angeordnet ist.

5. System nach Anspruch 3 oder 4, bei dem mehrere Empfangseinrichtungen (10) mit je einer Wiedergabeeinrichtung (6) an das Übertragungsmedium (3) gekoppelt sind.

6. System nach einem der vorhergehenden Ansprüche, bei dem die Signalverarbeitungseinrichtung (7, 8) ein Verhältnis von Spitzenleistung des akustischen Signals zu einer mittleren Leistung des akustischen Signals reduziert.

7. Verfahren zur leistungsoptimierten Wiedergabe eines akustischen Signals, bei dem
- ein akustisches Signal in einem ersten Frequenzband in ein elektrisches Signal umgewandelt wird,
- das elektrische Signal vom ersten Frequenzband in ein zweites Frequenzband umgesetzt wird,
- das elektrische Signal im zweiten Frequenzband amplitudenbegrenzt und gefiltert wird,
- das elektrische Signal vom zweiten Frequenzband in das erste Frequenzband umgesetzt wird, und
- das so verarbeitete elektrische Signal in ein akustisches Signal umgewandelt wird.

8. Verfahren nach Anspruch 7, bei dem ein Verhältnis von Spitzenleistung des akustischen Signals zu einer mittleren Leistung des akustischen Signals reduziert wird.

9. Gefahrenmeldeanlage mit mehreren Gefahrenmeldern, die jeweils einen Lautsprecher (6) zur Wiedergabe eines akustischen Alarmsignals oder einer Sprachmeldung aufweisen, und einem System zur leistungsoptimierten Wiedergabe eines akustischen Signals oder einer Sprachmeldung nach Anspruch 1, bei dem die in den Gefahrenmeldern vorhandenen Lautsprecher (6) das akustische Signal oder die Sprachmeldung wiedergeben.

10. Gefahrenmeldeanlage nach Anspruch 9, bei der mindestens eine Signalverarbeitungseinrichtung (7, 8) nach dem Prinzip des HF-Clippers vorhanden ist.

11. Gefahrenmeldeanlage nach Anspruch 10, bei der die Signalverarbeitungseinrichtung (7, 8) in einem Gefahrenmelder angeordnet ist.
